# EUROPEAN PATENT SPECIFICATION

(11) **EP 2 996 212 B1**
(45) Date of publication and mention of the grant of the patent: **21.10.2020**
(21) Application number: 15183870.3
(22) Date of filing: 04.09.2015
(51) Int. Cl.: H02B 1/052

(54) **RAIL MOUNTED FIXATION BRACKET**
SCHIENENMONTIERTER BEFESTIGUNGSHALTERUNG
SUPPORT DE FIXATION MONTÉ SUR RAIL

(30) Priority: 09.09.2014 CN 201420515268 U
(43) Date of publication of application: 16.03.2016
(73) Proprietor: Tyco Electronics (Shanghai) Co. Ltd., Shanghai 200131 (CN)
(72) Inventor: ZHONG, Yuan, Shanghai (CN); TAO, Ting, Shanghai (CN)
(74) Representative: Grünecker Patent- und Rechtsanwälte PartG mbB

(56) References cited:
- EP-A2- 0 909 122
- DE-A1-102007 015 470
- US-A- 5 842 889
- US-A- 6 135 825
- US-A1- 2002 093 794
- US-A1- 2003 143 896
- US-A1- 2012 262 894

## Description

### BACKGROUND OF THE INVENTION

### Field of the Invention

Embodiments of the present invention relate to a fixation bracket adapted to mount a circuit board thereon, and embodiments of the present invention further relate to a control device having the fixation bracket.

US2012262894 A1 discloses a fixation bracket comprising a pair of longitudinal beams, a pair of end plates and a pivoting snapping structure with an actuation surface below the fixation bracket. This surface can be engaged by, for example, a screw driver.

EP 0 909 122 A2 discloses an electric device for placement on a mounting rail, with a casing that consists of a lower casing section that can be detachably connected with the mounting rail, and an upper casing that can be detachably connected to the lower casing.

US 6,135,825 A discloses a connector for detachable fastening to a rail. The connector comprises at least one modular electric or electronic housing having at least one movable latching means and at least one lever arm for detachable fastening of the housing to the rail, where the latching means can be moved from a first locking position to a second unlocking position by a lever movement of a lever arm, and where the latching means has a spring with a free end which engages with a holding region of the housing in such a way that the latching means moves back from the second unlocking position into the first locking position upon release of the lever arm, and the lever arm has an abutment which cooperates with a side wall of the housing and is arranged at about half the distance between a joint for connecting to the latching means and an actuating region for actuating the lever arm.

In US 2002/0093794 A1, a housing for an electronic device which can be removably mounted onto a mounting rail is provided which includes a locking element located in an underside of the housing. The locking element can be moved from a first position in which the housing can be fastened onto the mounting rail into a second position wherein the housing can be lifted off the mounting rail. The locking element is associated with a retaining element for retaining the locking element in the second position. The retaining element includes a spring section extending substantially parallel to the locking element and a retaining section extending substantially perpendicularly thereto.

US 5,842,889 concerns an unlocking device for a lock fastening of clamps, modules, installation devices or the like on hat-shaped assembly rails. It is provided to use a bracing piece on the underside of the corresponding insulating material housing, which saves space in its rest position and is arched out toward the bottom into the free inside space of the assembly rail and whose back is pulled toward the top in its operating position by means of a pulling rod and in this way with its two ends, simultaneously and in opposite directions, presses out the locking feet of the lock fastening from the outer flange edges of the assembly rail.

US 2003/0143896 A1 discloses an electrical apparatus comprises a base which can accommodate a constituent member, and which can be fitted to a holding rail, in particular a top hat-type rail, via a locking device with two opposite fastening catches. A manual unlocking device on the slide comprises a lever pivoting around at least one bearing having an axis perpendicular to the sliding direction of the slide.

DE 10 2007 015 470 concerns a snap lock for mounting a housing to a rail. The snap lock comprises a slider with an actuating portion, a locking portion and a connecting portion, the connecting portion connecting the actuating portion and the locking portion.

### Description of the Related Art

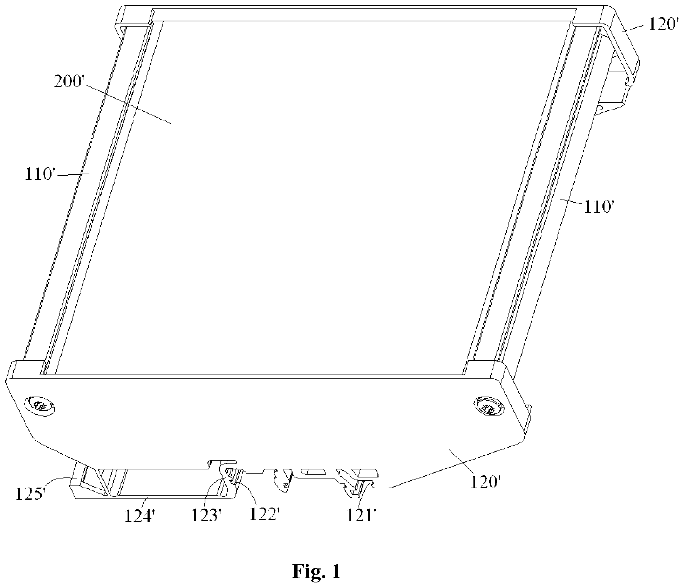

Fig. 1 shows a schematic perspective view of a fixation bracket for mounting a circuit board in the prior art.

As shown in Fig. 1, in the prior art, the fixation bracket comprises a pair of longitudinal beams 110' and a pair of end plates 120'. The pair of longitudinal beams 110' extends in a length direction of the fixation bracket. The pair of end plates 120' are connected to ends of the pair of longitudinal beams 110', respectively. A circuit board 200' is mounted on the fixation bracket.

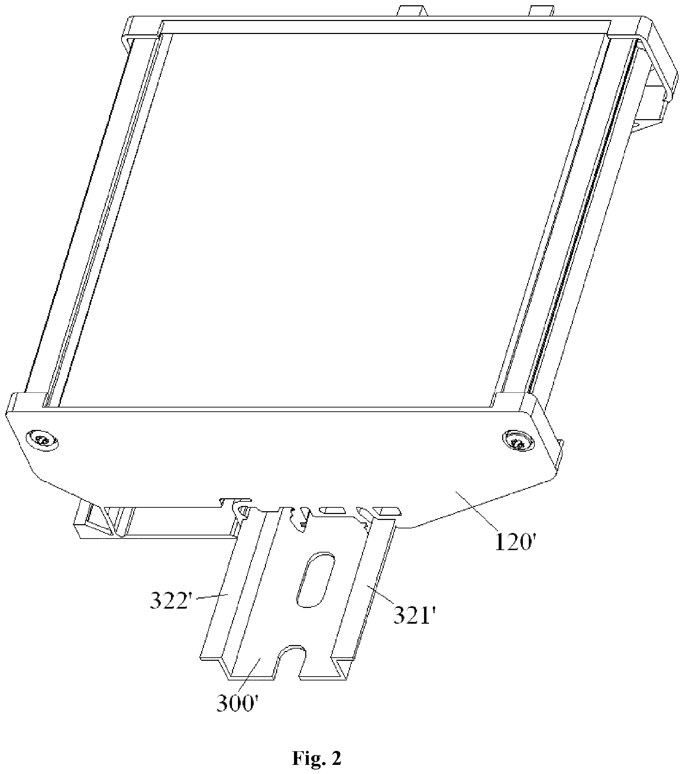

Fig. 2 shows a schematic view showing that the fixation bracket illustrated in Fig. 1 is snap-fitted onto a guide rail.

As shown in Figs. 1 and 2, in the prior art, an elastic snapping structure 121', 122', 123' is formed on a bottom of each end plates 120'. Each elastic snapping structures 121', 122', 123' comprises a pair of snapping slots 121', 122' and an elastic arm 123'. The pair of snapping slots 121', 122' are adapted to be snapped onto edges 321', 322' in both sides of the guide rail 300'. One snapping slot 122' of the pair of snapping slots 121', 122' is formed in the elastic arm 123'. The pair of snapping slots 121', 122' are constructed to face to each other in a width direction of the fixation bracket.

As shown in Figs. 1 and 2, in the prior art, the fixation bracket further comprises an connection arm 124' connected to the elastic arm 123', the connection arm 124' extends outwardly underneath the fixation bracket, and a protrusion 125' protruding upwardly is formed on an end of the connection arm 124' adjacent to an outer side of the fixation bracket.

The fixation bracket and the circuit board 200' mounted thereon are mounted in a cabinet (not shown) of a control device. In practical use, in order to satisfy maintenance requirements, it is sometimes desirable to disassemble the circuit board and the fixation bracket from the guide rail in the cabinet.

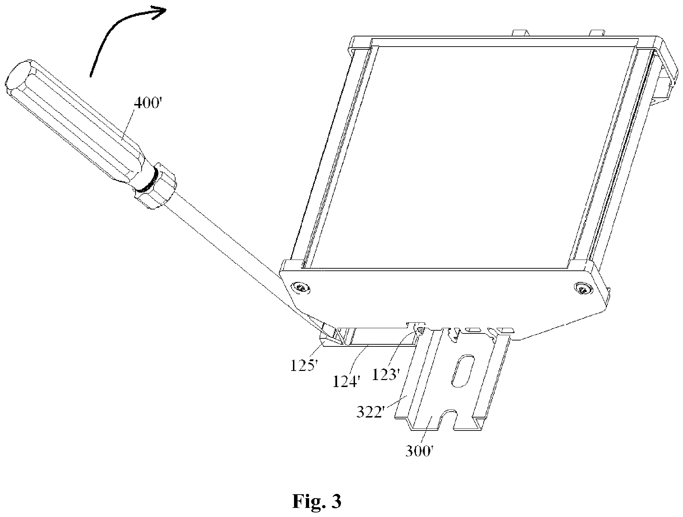

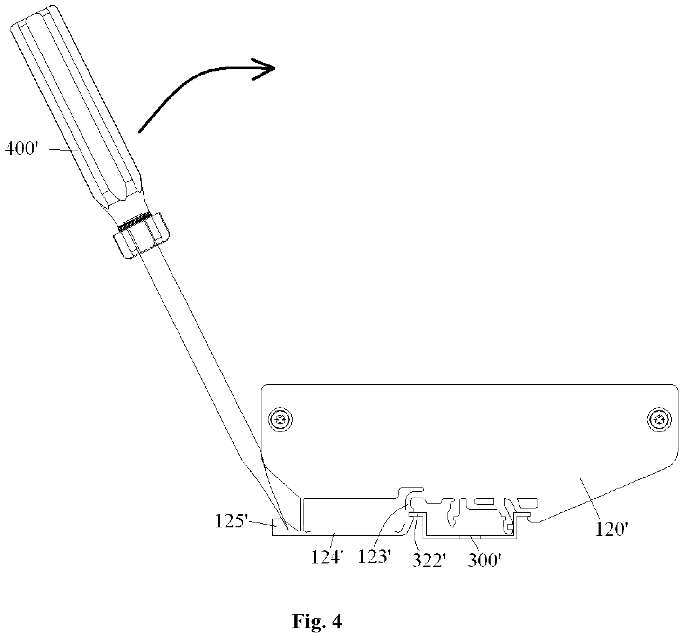

Fig. 3 shows a schematic perspective view showing that the fixation bracket mounted on the guide rail in the cabinet is disassembled from the guide rail by a screw driver; Fig. 4 shows a side view showing that the fixation bracket mounted on the guide rail in the cabinet is disassembled from the guide rail by a screw driver.

As shown in Figs. 3 and 4, the protrusion 125' protruding from the connection arm 124' may be pried by the screw driver 400' such that the snapping slot 122' on the bottom of the fixation bracket is detached from the edge 322' of the guide rail, thereby the fixation bracket is disassembled from the guide rail 300'.

As shown in Figs. 3 and 4, during disassembling, the screw driver 400' needs to be rotated by a certain angle in a direction indicated by the arrow, that is to say, an operation space must be provided for the screw driver 400', or else the fixation bracket cannot be disassembled from the guide rail 300'. Thus, relatively large spaces for the screw driver 400' at both sides of the fixation bracket are required to be not occupied, that is, any other components cannot be placed in the relatively large spaces at both sides of the fixation bracket, thereby causing waste of space. As a result, the number of the circuit boards placed in the cabinet is limited. In addition, since the protrusion 125' is located on the bottom of the fixation bracket, the sight line is blocked by the fixation bracket when an operator put the screw driver 400' onto the protrusion 125', thus he or she must observe the protrusion 125' from sides of the fixation bracket only by a particular angle, then put the screw driver 400 onto the protrusion 125' carefully, thereby causing an inconvenient operation.

### SUMMARY OF THE INVENTION

The objective of the present invention is to solve at least one aspect of the above problems and defects in the prior art.

One objective of the present invention is to provide a fixation bracket, which may be disassembled manually and simply from a guide rail by an operator, without requiring for any disassembling tools.

According to the present invention, there is provided a fixation bracket adapted to mount a circuit board thereon, comprising: a pair of longitudinal beams and a pair of end plates, the pair of end plates are connected to ends of the pair of longitudinal beams, respectively, an elastic snapping structure formed on a bottom of each end plate and engageable with a guide rail; and a connection arm connected to the elastic snapping structure, a part of the connection arm being located above the longitudinal beams and end plates wherein the elastic snapping structure is constructed to move away from the guide rail such that the elastic snapping structure is detachable from the guide rail when the connection arm is pulled by the part of the connection arm located above longitudinal beams and end plates, wherein the elastic snapping structure, the connection arm and the end plates are integrally formed. The elastic snapping structure is formed on a bottom of each of the end plates and the elastic snapping structure comprises: a pair of snapping slots adapted to be engaged with edges in both sides of the guide rail; and an elastic arm, in which one of the pair of snapping slots is formed.

According to another embodiment of the present invention, the connection arm comprises: a first arm portion connected to the elastic arm and extending away from the pair of snapping slots to one side of the fixation bracket underneath the bottom of the fixation bracket; a second arm portion connected to the first arm portion and extending upwardly above a top surface of the fixation bracket from the first arm portion beside the side of the fixation bracket; and a third arm portion connected to the second arm portion and extending towards the fixation bracket from the second arm portion above the top surface of the fixation bracket, the third arm portion being formed as a handle portion for facilitating an operator to grasp.

According to another embodiment of the present invention, the elastic arm and the snapping slot formed in the elastic arm are constructed to move away from the edge of the rail guide such that the snapping slot formed in the elastic arm is disengaged from the edge of the rail guide when the connection arm is pulled by the handle portion.

According to another embodiment of the present invention, the connection arm comprises: a first arm portion connected to the elastic arm and extending away from the pair of snapping slots to one side of the fixation bracket underneath the bottom of the fixation bracket; and a second arm portion connected to the first arm portion and extending upwardly above a top surface of the fixation bracket from the first arm portion beside the side of the fixation bracket, and wherein a hole is formed in the part of the second arm portion extending above the top surface of the fixation bracket to facilitate fingers of an operator insert into the hole and pull the connection arm upwardly.

According to another embodiment of the present invention, the connection arm is spaced from the end plates and extending substantially along an outer contour defined by the end plates.
According to another embodiment of the present invention, the second arm portion extends substantially in a height direction of the fixation bracket.

According to another embodiment of the present invention, the handle portion extends substantially in a width direction of the fixation bracket.

According to another aspect of the present invention, there is provided a control device comprising: a cabinet; a guide rail mounted in the cabinet; a fixation bracket, according to any one of the above described embodiments, received in the cabinet and mounted onto the guide rail; and a circuit board received in the cabinet and mounted onto the fixation bracket.

Other characteristics and advantages of the invention will be made clear by the following detailed description, the comprehension of which will be facilitated by reference to the attached drawings.

### BRIEF DESCRIPTION OF THE DRAWINGS

Fig. 1 shows a schematic perspective view of a fixation bracket for mounting a circuit board in the prior art.
Fig. 2 shows a schematic view showing that the fixation bracket illustrated in Fig. 1 is snap-fitted on a guide rail.
Fig. 3 shows a schematic perspective view showing that the fixation bracket mounted on the guide rail in the cabinet is disassembled from the guide rail by a screw driver;
Fig. 4 shows a side view showing that the fixation bracket mounted on the guide rail in the cabinet is disassembled from the guide rail by a screw driver.
Fig. 5 shows a schematic perspective view of a fixation bracket according to an exemplary embodiment of the present invention;
Fig. 6 shows a side view of the fixation bracket shown in Fig. 5;
Fig. 7 shows a schematic perspective view showing that the fixation bracket shown in Fig. 5 is assembled on a guide rail; and
Fig. 8 shows a side view showing that the fixation bracket shown in Fig. 5 is assembled onto the guide rail.

### DETAILED DESCRIPTION OF PREFERRED EMBODIMENTS OF THE INVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

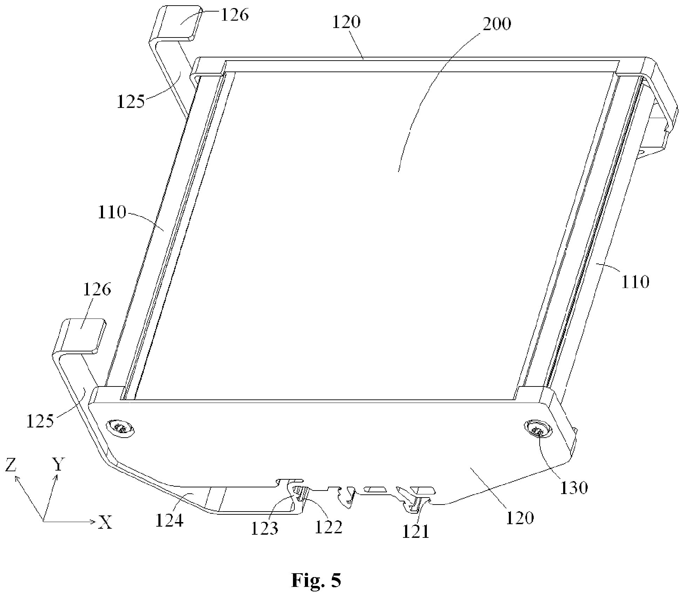

Fig. 5 shows a schematic perspective view of a fixation bracket according to an exemplary embodiment of the present invention.

As shown in Fig. 5, the fixation bracket primarily comprises a pair of longitudinal beams 110 extending in a length direction Y of the fixation bracket, and a pair of end plates 120 connected to opposite ends of the pair of longitudinal beams 110, respectively. In the embodiment illustrated, the end plates 120 are connected detachably to the ends of longitudinal beams 110, for example, by a threaded connection 130.

Further referring to Fig. 5, in the embodiment illustrated, a circuit board 200 is held and supported on the pair of longitudinal beams 110 and the pair of end plates 120 such that the circuit board 200 is mounted on the fixation bracket. The circuit board 200 may be removed when the end plates 120 are disassembled from the longitudinal beams 110.

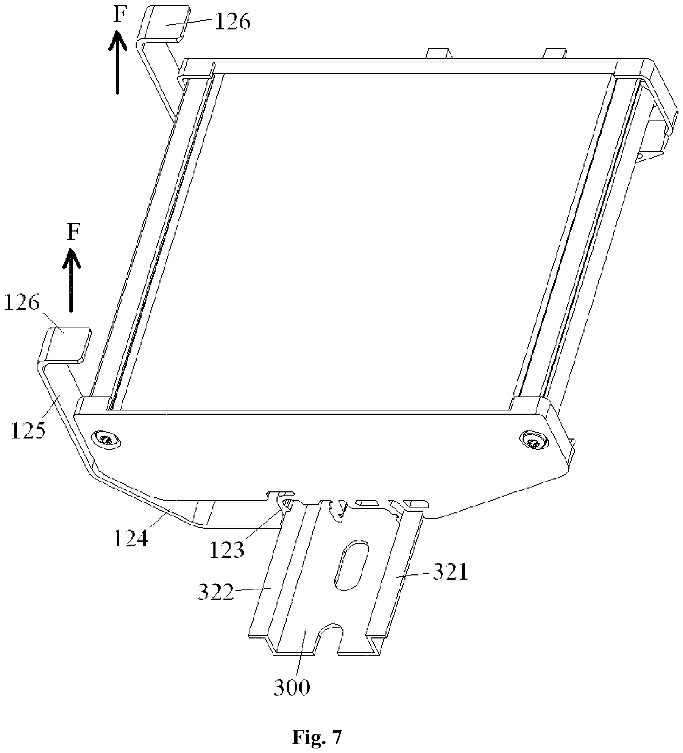

Fig. 7 shows a schematic perspective view showing that the fixation bracket shown in Fig. 5 is assembled onto a guide rail 300.

As shown in Figs. 5 and 7, the fixation bracket comprises an elastic snapping structure (further described in detail below) formed on a bottom of the fixation bracket and configured to be snapped on a guide rail 300 for supporting the fixation bracket.

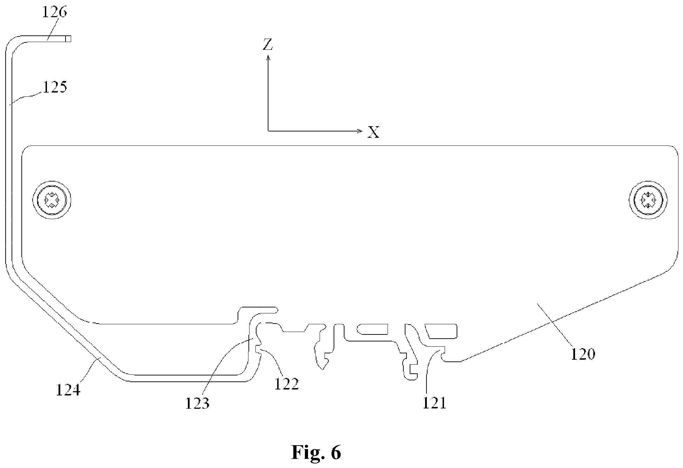

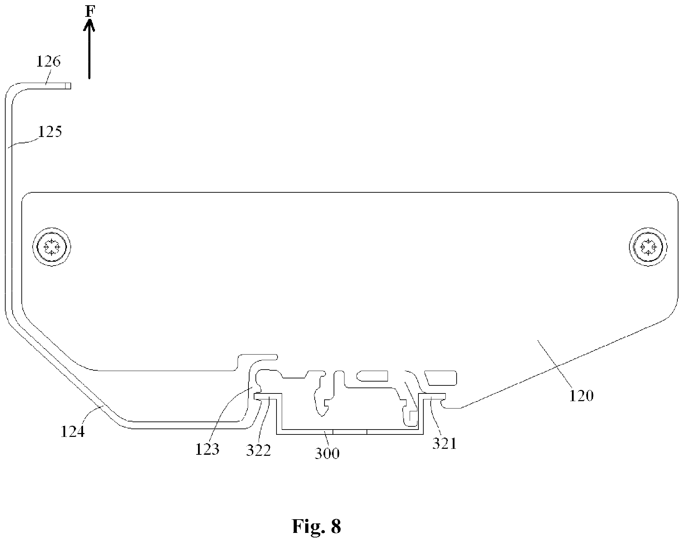

Fig. 6 shows a side view of the fixation bracket shown in Fig. 5; and Fig. 8 shows a side view showing that the fixation bracket shown in Fig. 5 is assembled onto the guide rail 300.

As shown in Figs. 5-8, an elastic snapping structure is formed on a bottom of each of the end plates 120. Each elastic snapping structures primarily comprises a pair of snapping slots 121, 122 for receiving edges 321, 322 of the guide rail 300 and an elastic arm 123. As shown in Figs. 5-8, the pair of snapping slots 121, 122 is configured to be snapped on the edges 321, 322 in both sides of the guide rail 300. One snapping slot 122 of the pair of snapping slots 121, 122 is formed in the elastic arm 123, which is configured to apply a resilient retention force to the guide rail 300, so as to the pair of snapping slots 121, 122 may be snapped firmly on the edges 321, 322 in both sides of the guide rail 300.

As shown in Figs. 5-8, in an exemplary embodiment of the present invention, the fixation bracket further comprises a connection arm (further described in detail below) connected to the elastic arm 123 of the elastic snapping structure, and the connection arm has a handle portion 126 located above the longitudinal beams (110) and end plates (120). When an operator grasps the handle portion 126 and pulls the connection arm upwardly in a direction indicated by the arrow F shown in Figs. 7 and 8, the elastic arm 123 of the elastic snapping structure moves away from the guide rail 300, and then the pair of snapping slots 121, 122 of the elastic snapping structure is detached from the edges 321, 322 of the guide rail 300, thus the fixation bracket may be disassembled from the guide rail 300.

As shown in Figs. 5-8, in an exemplary embodiment of the present invention, the connection arm primarily comprises a first arm portion 124, a second arm portion 125 and a third arm portion (handle portion) 126. In the embodiment illustrated, the first arm portion 124 is connected to the elastic arm 123 and extends, in a direction substantially parallel to the bottom of the fixation bracket, away from the pair of snapping slots 121, 122 to one side of the fixation bracket underneath the bottom of the fixation bracket. The second arm portion 125 is connected to the first arm portion 124 and extends upwardly above a top surface of the fixation bracket, in a direction substantially perpendicular to the first arm portion 124, from the first arm portion 124 beside the side of the fixation bracket. The third arm portion 126 is connected to the second arm portion 125 and extends towards an inner side of the fixation bracket from the second arm portion 125 above the top surface of the fixation bracket. In the embodiment illustrated, the third arm portion 126 forms a handle portion 126 for facilitating an operator to grasp. However, it should be noted that the handle portion 126 is not essential, and may be omitted in the present invention.

In another embodiment of the present invention, a hole may be formed in the part of the second arm portion 125 extending above the top surface of the fixation bracket, thus fingers of the operator may insert into the hole and pull the connection arm upwardly.

In the embodiment shown in Figs. 5-8, when the operator grasps the handle portion 126 and pulls the connection arm upwardly in a direction indicated by the arrow F shown in Figs. 7 and 8, the elastic arm 123 and the snapping slot 122 formed in the elastic arm 123 moves away from the edge 322 of the rail guide 300 such that the snapping slots 121, 122 formed in the elastic arm 123 is separated from the edges 321, 322 of the rail guide 300.

Therefore, in the embodiment illustrated, the connection arm may be pulled by means of the handle portion 126 such that the elastic snapping structure is detached from the guide rail 300, thus the fixation bracket may be disassembled manually and simply from the guide rail 300, without requiring for any special disassembling tools, and it does not need to leave a large operation space at both sides of the fixation bracket, thereby saving the space and reducing the volume of a cabinet of a control device for mounting the fixation bracket and the guide rail 300.

As shown in Figs. 5-8, in an exemplary embodiment of the present invention, the connection arm is spaced from the end plates 120 and extends substantially along an outer contour defined by the end plates 120.

As shown in Figs. 5-8, in the embodiment illustrated, the first arm portion 124 of the connection arm extends substantially along a bottom contour of the fixation bracket. The second arm portion 125 of the connection arm extends substantially in a height direction Z of the fixation bracket. The handle portion 126 of the connection arm extends substantially in a width direction X of the fixation bracket.

According to the present invention, as shown in Figs. 5-8, the elastic snapping structure, the connection arm and the end plates 120 are integrally formed.

According to another aspect of the present invention, there is further disclosed a control device. The control device primarily comprises a cabinet (not shown) mounted in the cabinet, a guide rail 300 mounted in the cabinet, a fixation bracket, according to any one of the above described embodiments, received in the cabinet and mounted on the guide rail 300, and a circuit board 200 received in the cabinet and mounted onto the fixation bracket.

In the fixation bracket according to various embodiments of the present invention, the fixation bracket comprises a connection arm connected to the elastic snapping structure, and the connection arm has a handle portion located above the fixation bracket. Therefore, the connection arm may be pulled by the handle portion such that the elastic snapping structure moves away from the guide rail, and then the elastic snapping structure is detached from the guide rail, thus the fixation bracket may be disassembled manually and simply from the guide rail, without requiring for any special disassembling tools, and it does not need to leave a large operation space at both sides of the fixation bracket, thereby saving the space and reducing the volume of the control cabinet.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles of the disclosure, the scope of which is defined in the claims.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A fixation bracket adapted to mount a circuit board (200) thereon, comprising:
a pair of longitudinal beams (110) and a pair of end plates (120), the pair of longitudinal beams (110) extending in a length direction (Y) of the fixation bracket, the pair of end plates (120) being connected to ends of the pair of longitudinal beams (110), respectively;
an elastic snapping structure formed on a bottom of each end plate (120) and engageable with a guide rail (300), the elastic snapping structure comprising:
a pair of snapping slots (121, 122) adapted to be engaged with edges (321, 322) in both sides of the guide rail (300) and
an elastic arm (123), in which one of the pair of snapping slots (121, 122) is formed;
and
a connection arm (124,125,126) connected to the elastic snapping structure, a part of the connection arm being located above the longitudinal beams (110) and end plates (120),
wherein the elastic snapping structure is constructed to move away from the guide rail (300) such that the elastic snapping structure is detachable from the guide rail (300) when the connection arm is pulled by the part of the connection arm located above the longitudinal beams (110) and end plates (120), and wherein the elastic snapping structure, the connection arm and the end plates (120) are integrally formed.

2. The fixation bracket according to claim 1, wherein the connection arm comprises:
a first arm portion (124) connected to the elastic arm (123) and extending away from the pair of snapping slots (121, 122) to one side of the fixation bracket underneath the bottom of the fixation bracket;
a second arm portion (125) connected to the first arm portion (124) and extending upwardly above a top surface of the fixation bracket from the first arm portion (124) beside the side of the fixation bracket; and
a third arm portion (126) connected to the second arm portion (125) and extending towards the fixation bracket from the second arm portion (125) above the top surface of the fixation bracket, the third arm portion (126) being formed as a handle portion (126) for facilitating an operator to grasp.

3. The fixation bracket according to claim 1, wherein the connection arm comprises:
a first arm portion (124) connected to the elastic arm (123) and extending away from the pair of snapping slots (121, 122) to one side of the fixation bracket underneath the bottom of the fixation bracket; and
a second arm portion (125) connected to the first arm portion (124) and extending upwardly above a top surface of the fixation bracket from the first arm portion (124) beside the side of the fixation bracket, and
wherein a hole is formed in the part of the second arm portion (125) extending above the top surface of the fixation bracket to facilitate fingers of an operator to insert into the hole and pull the connection arm upwardly.

4. The fixation bracket according to claim 2, wherein,
the elastic arm (123) and the snapping slot (122) formed in the elastic arm (123) are constructed to move away from the edge (322) of the rail guide such that the snapping slot (122) formed in the elastic arm (123) is disengaged from the edge (322) of the rail guide when the connection arm is pulled by the handle portion (126).

5. The fixation bracket according to claim 4, wherein,
the connection arm is spaced from the end plates (120) and extend substantially along an outer contour defined by the end plates (120).

6. The fixation bracket according to claim 5, wherein the second arm portion (125) extends substantially in a height direction (Z) of the fixation bracket.

7. The fixation bracket according to claim 6, wherein the handle portion (126) extends substantially in a width direction (X) of the fixation bracket.

8. A control device comprising:
a cabinet;
a guide rail (300) mounted in the cabinet;
the fixation bracket, according to any one of preceding claims, received in the cabinet and mounted onto the guide rail (300); and
a circuit board (200) received in the cabinet and mounted onto the fixation bracket.

## Patentansprüche

1. Befestigungskonsole, die zum Anbringen einer Leiterplatte (200) daran eingerichtet ist, wobei sie umfasst:
ein Paar Längsträger (110) sowie ein Paar Endplatten (120), wobei sich die paarigen Längsträger (110) in einer Längsrichtung (Y) der Befestigungskonsole erstrecken und die paarigen Endplatten (120) jeweils mit Enden der paarigen Längsträger (110) verbunden sind;
eine elastische Einrast-Struktur, die an einer Unterseite jeder Endplatte (120) ausgebildet ist und mit einer Führungsschiene (300) in Eingriff gebracht werden kann, wobei die elastische Einrast-Struktur umfasst:
ein Paar Einrast-Schlitze (121, 122), die so eingerichtet sind, dass sie mit Kanten (321, 322) an beiden Seiten der Führungsschiene (300) in Eingriff gebracht werden, und
einen elastischen Arm (123), in dem einer der paarigen Einrast-Schlitze (121, 122) ausgebildet ist;
sowie
einen Verbindungsarm (124, 125, 126), der mit der elastischen Einrast-Struktur verbunden ist, wobei sich ein Teil des Verbindungsarms oberhalb der Längsträger (110) und der Endplatten (120) befindet,
wobei die elastische Einrast-Struktur so konstruiert ist, dass sie sich so von der Führungsschiene (300) weg bewegt, dass die elastische Einrast-Struktur von der Führungsschiene (300) gelöst werden kann, wenn der Verbindungsarm über den Teil des Verbindungsarms gezogen wird, der sich oberhalb der Längsträger (110) und der Endplatten (120) befindet, und wobei die elastische Einrast-Struktur, der Verbindungsarm und die Endplatten (120) integral ausgebildet sind.

2. Befestigungskonsole nach Anspruch 1, wobei der Verbindungsarm umfasst:
einen ersten Armabschnitt (124), der mit dem elastischen Arm (123) verbunden ist und sich von den paarigen Einrast-Schlitzen (121, 122) zu einer Seite der Befestigungskonsole unterhalb der Unterseite der Befestigungskonsole erstreckt;
einen zweiten Armabschnitt (125), der mit dem ersten Armabschnitt (124) verbunden ist und sich von dem ersten Armabschnitt (124) neben der Seite der Befestigungskonsole nach oben bis über eine obere Fläche der Befestigungskonsole erstreckt; sowie
einen dritten Armabschnitt (126), der mit dem zweiten Armabschnitt (125) verbunden ist und sich von dem zweiten Armabschnitt (125) bis über die Oberseite der Befestigungskonsole auf die Befestigungskonsole zu erstreckt, wobei der dritte Armabschnitt (126) als Griffabschnitt (126) ausgebildet ist, um einer Bedienungsperson das Greifen zu ermöglichen.

3. Befestigungskonsole nach Anspruch 1, wobei der Verbindungsarm umfasst:
einen ersten Armabschnitt (124), der mit dem elastischen Arm (123) verbunden ist und sich von den paarigen Einrast-Schlitzen (121, 122) zu einer Seite der Befestigungskonsole unterhalb der Unterseite der Befestigungskonsole erstreckt; sowie
einen zweiten Armabschnitt (125), der mit dem ersten Armabschnitt (124) verbunden ist und sich von dem ersten Armabschnitt (124) neben der Seite der Befestigungskonsole nach oben bis über eine obere Fläche der Befestigungskonsole erstreckt; und
wobei ein Loch in dem Teil des zweiten Armabschnitts (125) ausgebildet ist, der sich oberhalb der oberen Fläche der Befestigungskonsole erstreckt, um es einer Bedienungsperson zu ermöglichen, Finger in das Loch einzuführen und den Verbindungsarm nach oben zu ziehen.

4. Befestigungskonsole nach Anspruch 2, wobei
der elastische Arm (123) und der in dem elastischen Arm (123) ausgebildete Einrast-Schlitz (122) so konstruiert sind, dass sie sich so von der Kante (322) der Schienenführung weg bewegen, dass der in dem elastischen Arm (123) ausgebildete Einrast-Schlitz (122) von der Kante (322) der Schienenführung gelöst wird, wenn der Verbindungsarm über den Griffabschnitt (126) gezogen wird.

5. Befestigungskonsole nach Anspruch 4, wobei
der Verbindungsarm von den Endplatten (120) beabstandet ist und sich im Wesentlichen an einer durch die Endplatten (120) gebildeten Außenkontur entlang erstreckt.

6. Befestigungskonsole nach Anspruch 5, wobei sich der zweite Armabschnitt (125) im Wesentlichen in einer Höhenrichtung (Z) der Befestigungskonsole erstreckt.

7. Befestigungskonsole nach Anspruch 6, wobei sich der Griffabschnitt (126) im Wesentlichen in einer Breitenrichtung (X) der Befestigungskonsole erstreckt.

8. Steuerungsvorrichtung, die umfasst:
ein Gehäuse;
eine Führungsschiene (300), die in dem Gehäuse angebracht ist;
die Befestigungskonsole nach einem der vorangehenden Ansprüche, die in dem Gehäuse aufgenommen und an der Führungsschiene (300) angebracht wird; und
eine Leiterplatte (200), die in dem Gehäuse aufgenommen und an der Befestigungskonsole angebracht wird.

## Revendications

1. Support de fixation adapté pour y monter un circuit imprimé (200), comprenant :
une paire de poutres longitudinales (110) et une paire de plaques d'extrémité (120), la paire de poutres longitudinales (110) s'étendant en direction de la longueur (Y) du support de fixation, les plaques de la paire de plaques d'extrémité (120) étant respectivement connectées aux extrémités de la paire de poutres longitudinales (110) ;
une structure d'enclenchement élastique formée sur le fond de chaque plaque d'extrémité (120) et pouvant être engagée avec un rail de guidage (300), la structure d'enclenchement élastique comprenant :
une paire de rainures d'enclenchement (121, 122) adaptées pour être engagées avec des bords (321, 322) des deux côtés du rail de guidage (300) et
un bras élastique (123) dans lequel est formée une rainure de la paire de rainures d'enclenchement (121, 122) ; et
un bras de connexion (124, 125, 126) connecté à la structure d'enclenchement élastique, une partie du bras de connexion se trouvant au-dessus des poutres longitudinales (110) et des plaques d'extrémité (120),
dans lequel la structure d'enclenchement élastique est conçue de manière à s'éloigner du rail de guidage (300) de telle sorte que la structure d'enclenchement élastique peut se détacher du rail de guidage (300) quand le bras de connexion est tiré par la partie du bras de connexion se trouvant au-dessus des poutres longitudinales (110) et des plaques d'extrémité (120), et dans lequel la structure d'enclenchement élastique, le bras de connexion et les plaques d'extrémité (120) sont conformés de manière intégrée.

2. Support de fixation selon la revendication 1, dans lequel le bras de connexion comprend :
une première portion de bras (124) connectée au bras élastique (123) et qui s'étend en s'éloignant de la paire de rainures d'enclenchement (121, 122) d'un côté du support de fixation sous le fond du support de fixation ;
une deuxième portion de bras (125) connectée à la première portion de bras (124) et qui s'étend vers le haut au-dessus d'une surface supérieure du support de fixation depuis la première portion de bras (124) près du côté du support de fixation ; et
une troisième portion de bras (126) connectée à la deuxième portion de bras (125) et qui s'étend vers le support de fixation depuis la deuxième portion de bras (125) au-dessus de la surface supérieure du support de fixation, la troisième portion de bras (126) étant formée comme une portion de poignée (126) pour faciliter sa saisie par un opérateur.

3. Support de fixation selon la revendication 1, dans lequel le bras de connexion comprend :
une première portion de bras (124) connectée au bras élastique (123) et qui s'étend en s'éloignant de la paire de rainures d'enclenchement (121, 122) d'un côté du support de fixation sous le fond du support de fixation ; et
une deuxième portion de bras (125) connectée à la première portion de bras (124) et qui s'étend vers le haut au-dessus d'une surface supérieure du support de fixation depuis la première portion de bras (124) près du côté du support de fixation, et
dans lequel un trou est formé dans la partie de la deuxième portion de bras (125) qui s'étend au-dessus de la surface supérieure du support de fixation pour faciliter l'insertion des doigts d'un opérateur dans le trou et pour tirer le bras de connexion vers le haut.

4. Support de fixation selon la revendication 2, dans lequel
le bras élastique (123) et la rainure d'enclenchement (122) formée dans le bras élastique (123) sont conçus pour s'éloigner du bord (322) du rail de guidage de telle sorte que la rainure d'enclenchement (122) formée dans le bras élastique (123) est désengagée du bord (322) du rail de guidage quand le bras de connexion est tiré par la portion de poignée (126) .

5. Support de fixation selon la revendication 4, dans lequel le bras de connexion est espacé des plaques d'extrémité (120) et s'étend substantiellement le long d'un contour externe défini par les plaques d'extrémité (120).

6. Support de fixation selon la revendication 5, dans lequel la deuxième portion de bras (125) s'étend substantiellement en direction de la hauteur (Z) du support de fixation.

7. Support de fixation selon la revendication 6, dans lequel la portion de poignée (126) s'étend substantiellement en direction de la largeur (X) du support de fixation.

8. Dispositif de contrôle comprenant :
une armoire ;
un rail de guidage (300) monté dans l'armoire ;
le support de fixation selon l'une quelconque des revendications précédentes, reçu dans l'armoire et monté sur le rail de guidage (300) ; et
un circuit imprimé (200) reçu dans l'armoire et monté sur le support de fixation.
